(19) **Europäisches Patentamt**
**European Patent Office**
**Office européen des brevets**

(11) **EP 3 306 672 A1**

(12) **EUROPEAN PATENT APPLICATION**

(43) Date of publication:
**11.04.2018 Bulletin 2018/15**

(51) Int Cl.:
*H01L 29/78* (2006.01)          *H01L 29/06* (2006.01)
*H01L 29/08* (2006.01)          *H01L 21/336* (2006.01)
*H01L 29/739* (2006.01)        *H01L 21/331* (2006.01)

(21) Application number: **16192747.0**

(22) Date of filing: **07.10.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ABB Schweiz AG**
**5400 Baden (CH)**

(72) Inventors:
• **BAUER, Friedhelm**
**6714 Semione (CH)**
• **BELLINI, Marco**
**8952 Schlieren (CH)**
• **VEMULAPATI, Umamaheswara**
**5430 Wettingen (CH)**

(74) Representative: **ABB Patent Attorneys**
**c/o ABB Schweiz AG**
**Intellectual Property CH-IP**
**Brown Boveri Strasse 6**
**5400 Baden (CH)**

(54) **SEMICONDUCTOR DEVICE**

(57)     A semiconductor device comprising a MOS cell (1) having an n doped source layer (2), a p doped base layer (3) and a first drift section (4), which comprises an n doped first pillar (40, 40'), and a p doped second pillar (42), which is arranged alternatingly to the first pillar (40, 40').

Between the first drift section (4) and the second main side (12) a second drift section (5) is arranged comprising an n doped third pillar (50, 50') and a p doped fourth pillar (52), which is arranged alternatingly to the third pillar (50, 50'). The first drift section (4) is separated from the second drift section (5) by a continuous n doped drift layer (6). An integral of a doping concentration over dV in the first or third pillar corresponds to an integral of a doping concentration over dV in the second or fourth pillar times a factor k, which is between 0.8 and 1.2.

FIG 1

## Description

### Technical Field

The invention relates to the field of power electronics and more particularly to a semiconductor device according to the preamble of claim 1 and to a method for manufacturing such a semiconductor device.

### Background Art

US 6 693 323 B2 describes a superjunction silicon device, which comprises an n doped source layer and a p doped base layer, both of which contact a source electrode. A MOS channel is formable during operation of the device from the source layer via the base layer to an n- doped layer. The n- doped layer is arranged on an n+ doped drain layer, which contacts a drain electrode. For providing a superjunction device, the n- doped layer alternates with a p- doped layer. The n- doped layer and the p- doped layer have the same width of 5 $\mu$m, the same thickness of 25 $\mu$m and the same doping concentration of 7 x 10$^{15}$ cm$^{-3}$. The alternating p / n structure is formed either by providing an n+ substrate, on which an n- doped epitaxial layer is grown. In the epitaxial layer, trenches are etched, which are afterwards filled by epitaxially growing a p- doped layer in the trenches. Alternatively to this etching method, an n+ substrate may be provided, on which an n- or p- doped epitaxial layer is grown. In this epitaxial layer a dopant of a different dopant type (p- on n- substrate or n- on p- substrate) is implanted and diffusing the dopant into the epitaxial layer.

On a second n doped substrate the base layer and the source layer are formed and on top of these layers, a gate electrode is formed. Afterwards the second substrate thickness is reduced to the depth of the base layer. Now, both substrates are bonded together.

However, these methods are limited in the thickness for the superjunction structure, because of limited depth, to which a dopant may be implanted and annealed and limited thickness, to which a trench may be etched and filled afterwards with a dopant. Furthermore, the alignment between the source sided structure and the superjunction structure in the $\mu$m-range is very difficult and may lead to misalignments, by which no MOS channel is formable between the source layer via the base layer to the n- doped layer.

For a prior art vertical superjunction power MOSFET, the blocking capability is mainly determined by the pillar height. A prior art superjunction device can achieve the same breakdown voltage as a conventional power MOSFET while using only about 80 % of the thickness of the conventional drift layer. Depending on the doping density and the width of the pillars, a fraction of the on-resistance of the conventional power MOSFET can be achieved if the superjunction geometry meets the following criterion: the doping concentration of the pillars, in which only the n doped pillars contribute to current conduction, needs to be significantly larger than the drift layer doping concentration of the conventional MOSFET. However, increasing the doping concentration of the pillars also requires to shrink the width of the pillars since the superjunction geometry needs to be fully depleted when blocking. This results in an increase of the aspect ratio (ratio of the pillar width to thickness).

In order to design a superjunction power MOSFET, which provides high breakdown voltage and low on-resistance, highly doped pillars with large height and narrow width have to be achieved, i.e. a high aspect ratio.

On the other hand, superjunction structures are sensitive to variations from an ideal charge compensation in the n and p doped pillars. The deviation in charge balance has to be kept small in order to enable a high breakdown voltage. However, maintaining a low value of charge imbalance will become increasingly difficult when the aspect ratio is large, i.e., when pillar height is large, pillar width is small and pillar doping concentration is high.

In order to overcome this limitation, another method is described in US 6 693 323 B2, in which two superjunction structures as described above are formed and a source sided structure. These three structures are bonded together resulting in a device with two bonding planes. However, this method has the disadvantage of the two bonding interlayers, in which more defects are present. Such defects may lead to field peaks and cause instabilities in the device. Additionally to the bonding difficulties between the source sided structure and the first superjunction structure, also the bonding of the two p/n superjunction sandwich-structures having layers with widths in the $\mu$m-range is very difficult due to the necessity to align both superjunction structures in order to ensure a continuous drift layer between the base layer and the drain layer. Furthermore, the handling of the very thin and therefore fragile structures is difficult, therefore making such a process unattractive for production.

With such a double or multiple superjunction structure, the breakdown voltage can tremendously be increased. The additional processing steps do not bring more complexity into the process than for a single superjunction structure, but make it possible to increase the n-doped base layer thickness by factors of the single superjunction thickness. Due to the integration of a continuous drift layer in between two superjunction structures, there is no sophisticated alignment of the superjunction structures needed, because the continuous n- doped layer is established in all cases by the continuous drift layer, which connects the two n-doped pillars of the first and second superjunction structures and thereby, maintains the MOS channel to the second main side.

### Disclosure of Invention

A semiconductor device is provided comprising a MOS cell having from a first main side to a second main side opposite to the first main side following layers:

- a source layer of a first conductivity type,

- a base layer of a second conductivity type different from the first conductivity type,

- a first drift section comprising a first pillar of the first conductivity type, which is lower doped than the source layer, and a second pillar of the second conductivity type, which is arranged alternatingly to the first pillar.

A gate electrode is arranged on the first main side, which gate electrode comprises an electrically conductive gate layer, which is insulated from any doped layer by an insulating layer. A MOS channel is formable from the source layer via the base layer to the first pillar.

Between the first drift section and the second main side a second drift section is arranged comprising a third pillar of the first conductivity type, which is lower doped than the source layer, and a fourth pillar of the second conductivity type, which is arranged alternatingly to the third pillar. The first drift section is separated from the second drift section by a continuous drift layer of the first conductivity type.

The following relationship is fulfilled:

$$\int_0^{V_A} N_A * dV = k * \int_0^{V_B} N_B * dV,$$

wherein

$N_A$ is a local doping concentration in a pillar A,
$V_A$ is a volume of the pillar A,
$N_B$ is a local doping concentration in a pillar B,
$V_B$ is a volume of the pillar B,
k is a factor between 0.8 and 1.2.

The formula holds true for pillar A being the first pillar and pillar B being the second pillar, and the formula is fulfilled for pillar A being the third pillar and pillar B being the fourth pillar.

The inventive semiconductor device overcomes the limitations of prior art semiconductor devices in view of aspect ratio and charge balance. The voltage blocking capability can be increased compared to a single-side prior art superjunction device without increasing the requirements on the superjunction technology (aspect ratio, pillar doping concentration, charge imbalance).

On the other hand, compared to an existing single-sided superjunction power MOSFET with given breakdown voltage, the inventive geometry allows to manufacture a double-sided device with the same breakdown voltage but at a lower requirement (lower aspect ratio, higher yield, eventually lower cost) on the technology.

Top and bottom superjunction geometries can have different designs on the first and second main side regarding the structure of the pillars. For example, one layer may feature a stripe pattern for the pillars while the other superjunction structure may feature a columnar layout (for example, columns of one conductivity type fully surrounded by a layer of the other conductivity type).

First and second drift sections may feature different aspect ratios (different pillar *width and pillar height) as well as different pillar doping concentrations.*

Further exemplary embodiments of the inventive subject matter are disclosed in the dependent claims.

***Brief Description of Drawings***

The subject matter of the invention will be explained in more detail in the following text with reference to the attached drawings, in which:

| | |
|---|---|
| FIG 1 | shows a cross sectional view of an inventive MOS cell; |
| FIG 2 | shows a cross sectional view of an inventive MOSFET having a planar gate electrode; |
| FIG 3 | shows a cross sectional view of an inventive MOSFET having a trench gate electrode; |
| FIG 4 | shows a cross sectional view of an inventive MOSFET having first and second drift sections with different thicknesses; |
| FIG 5 | shows a cross sectional view of an inventive MOSFET with a contact base layer; |
| FIG 6 | shows a cross sectional view of an inventive MOSFET with a floating layer in the drift layer; and |
| FIG 7 | shows a cross sectional view of an inventive non punch-through IGBT; |
| FIG 8 | shows a cross sectional view of an inventive punch-through IGBT; |
| FIG 9 | shows a cross sectional view of an inventive reverse-conducting IGBT; |
| FIG 10 | shows a cross sectional view of an inventive MOSFET with a further second drift section; |
| FIGs 11 to 19 | show a manufacturing method for an inventive semiconductor device; |
| FIG 20 to 22 | shows another manufacturing method for an inventive semiconductor device; and |
| FIG 23 | shows a cross sectional view of an inventive MOSFET having two MOS cells. |

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

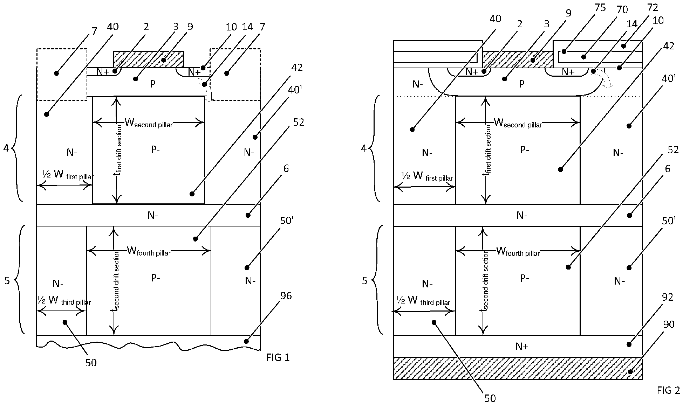

FIG 1 shows a cross sectional view of an inventive MOS cell 1. The MOS cell 1 comprises from a first main side 10 to a second main side 12 opposite to the first main side 10 following layers:

- a source layer 2 of a first conductivity type, which is n type in an exemplary embodiment,

- a base layer 3 of a second conductivity type different from the first conductivity type, which is p type in this exemplary embodiment,

- a first drift section 4 comprising an n doped first pillar 40, 40', which is lower doped than the source layer, and a p doped second pillar 42, which is arranged in the same plane and alternatingly to the first pillar 40, 40'.

On the second main side 12 a second main sided layer 96 is arranged which is either p or n doped depending on the semiconductor type.

In an exemplary embodiment, the doped layers are made of a wide bandgap material, exemplarily of silicon carbide such as 4H SiC or of gallium nitride. In another exemplary embodiment, the doped layers may be made of silicon.

A gate electrode 7 is arranged on the first main side 10, which gate electrode comprises an electrically conductive gate layer 70, which is insulated from any doped layer by an insulating layer 72. In FIG 1, the gate electrode 7 is shown by a dashed area to indicate that the inventive MOS cell may comprise different gate electrodes 7, exemplarily a planar gate electrode 75 or trench gate electrode 77. A MOS channel 14 is formable from the source layer 2 via the base layer 3 to the first pillar 40, 40'.

The insulating layer 72 may be made of an insulating material, wherein also a dielectric like a metal oxide, exemplarily Silicon dioxide, shall be considered as an insulating layer. The insulating layer 72 comprises a first insulating layer towards the doped layers and a covering second insulating layer on top of the gate layer. The covering second insulating layer can also be made as a stack of different insulating layers. In case of the insulating layer being a metal oxide layer the channel described above is called a MOS channel (metal oxide semiconductor), whereas otherwise (first and second insulating layers being made of another insulating material) the channel may also be called MIS channel (metal insulator semiconductor). As a material for the gate layer 70 any appropriate electrically conductive material like a metal or polysilicon may be used.

The inventive method can be used to create different sorts of MOS devices like a MOSFET/MISFET (metal-oxide-semiconductor field-effect transistor) device or an IGBT (insulated gate bipolar transistor) device. For the purpose of this patent application all kinds of MIS devices shall also be considered as MOS devices.

The first pillar 40, 40' has a first drift section thickness $t_{first\ drift}$ section. The first drift section thickness is measured from the deepest extension of the interface between the base layer 3 and the first drift section 4 to the interface between the first drift section 4 and the drift layer 6. The first pillar 40, 40' has a first pillar width $W_{first\ pillar}$, which shall correspond to the largest diameter of a circle, which can be laid into the first pillar 40, 40' in a plane parallel to the first main side 10. In FIG 1, a MOS cell is shown, which comprises in one cell two half first pillars 40, 40'. A cell shall be such area in the device, in which a first main electrode 9 contacts the doped layers and provides MOS channels 14, exemplarily two at each lateral side to the first main side electrode contact.

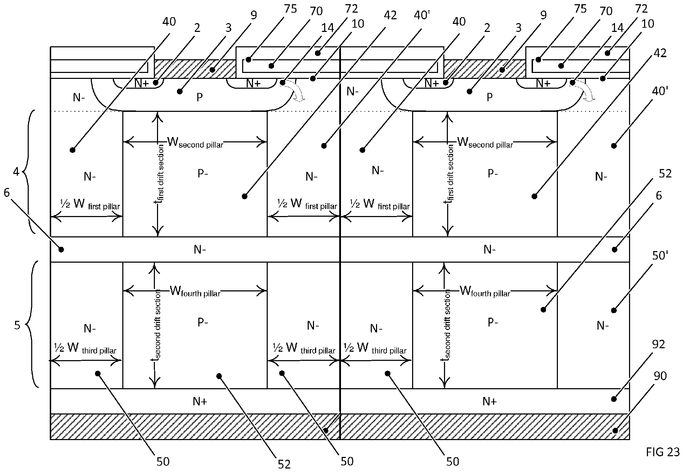

The width $W_{first\ pillar}$ shall correspond of the sum of these two half pillars 40, 40'. If the device comprises a plurality of MOS cell arranged repetitively, i.e. the MOS cell shown in FIG 1 is repeated on the lateral sides. Lateral shall mean lateral in a plane parallel to the first main side and lateral to the two channels in one cell. Additionally, such cells may also be repeated in the third dimension, i.e. in a direction perpendicular to the cross sectional view shown in FIG 1. If the cells are repeated laterally, the first pillar half width shall be measured for the common first pillar 40, 40' belonging to adjacent cells from the border to the center of the n doped first pillars 40, 40' (FIG 23, which shows exemplarily the MOS cells in an inventive MOSFET).

In each cell, a first main electrode 9, which is a source electrode in the case of a MOSFET, contacts the source layer 2 and the base layer 3. The source layer comprises two source regions on both lateral sides of the source electrode. MOS channels 14 are formable at both source regions, i.e. at each MOS cell two MOS channels are formable. The source layer 2 may have a doping concentration in the range of $1 \times 10^{17}$ cm$^{-3}$ to $1 \times 10^{20}$ cm$^{-3}$ and a thickness between 0.1 to 1 $\mu$m.

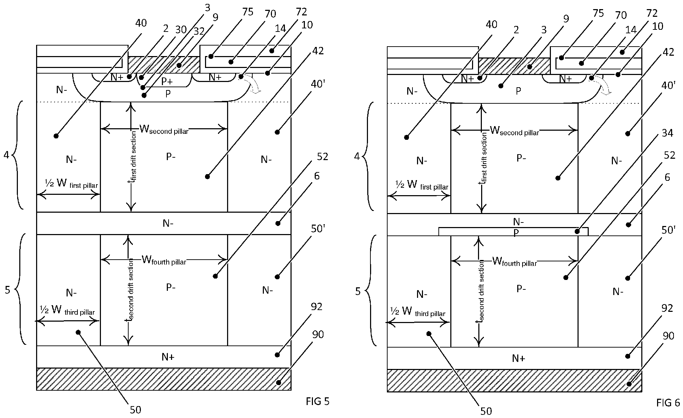

The base layer 3 may have a doping concentration in the range of $1 \times 10^{16}$ cm$^{-3}$ to $1 \times 10^{20}$ cm$^{-3}$ and a thickness between 0.2 to 3 $\mu$m, which is in all cases thicker than the source layer 2 so that the base layer 3 separates the source layer 2 from the first drift section 4. In an exemplary embodiment, the base layer 3 may comprise a contact base layer 30 and a base region 32 (FIG 5). The contact base layer 30 contacts the first main electrode 9 and due to its high doping concentration between $1 \times 10^{17}$ cm$^{-3}$ to $1 \times 10^{20}$ cm$^{-3}$ establishes a good and reliable ohmic contact. In such a device, the base region 32 has a lower doping concentration in the range of $1 \times 10^{16}$ cm$^{-3}$ to $1 \times 10^{18}$ cm$^{-3}$, which doping concentration is achieved at the interface to the first drift section 4. In an exemplary embodiment, the doping concentration of the base region 32 may be a factor 2 to a factor of 100 higher than the doping concentration of the second pillar 42.

Between the first drift section 4 and the second main side 12, i.e. the second main sided layer 96, a second drift section 5 is arranged, which comprises an n doped third pillar 50, 50', which is lower doped than the source layer 2, and a p doped fourth pillar 52, which is arranged alternatingly to the third pillar 50, 50'.

In the first drift section and in the second drift section 5 a formula is fulfilled:

$$\int_0^{V_A} N_A * dV = k * \int_0^{V_B} N_B * dV,$$

in which

N_A is a local doping concentration in a pillar A,
V_A is a volume of the pillar A,
N_B is a local doping concentration in a pillar B,
V_B is a volume of the pillar B,
k is a factor between 0.8 and 1.2, exemplarily between 0.9 and 1.1 or between 0.95 and 1.05.

The formula is fulfilled for pillar A being the first pillar 40, 40' and pillar B being the second pillar 42. The formula is also fulfilled for pillar A being the third pillar 50, 50' and pillar B being the fourth pillar 52. That means that the amount of doping in the whole volume of the first pillar 40, 40' corresponds to the amount of doping in the whole volume of the second pillar 42. The same applies for the second drift section 5 with the third and fourth pillar 50, 50', 52.

The first drift section 4 is separated from the second drift section 5 by a continuous n doped drift layer 6. The drift layer 6 extends as a separation layer between the second pillar 42 and fourth pillar 52 over the whole plane between the first drift section 4 and the second drift section 5, such that the p doped second pillar 42 and the fourth pillar 52 are separated by the n doped drift layer 6.

A thickness of the first drift section 4, plus the thickness of the drift layer 6 and thickness of the second drift section 5 strongly depends on the desired voltage class of the device. For low voltage classes first and second drift section 4, 5 thicknesses, each of 10 $\mu$m may be sufficient thick, whereas for a high voltage class, each drift section thickness up to 100 $\mu$m may be used. Therefore, in an exemplary embodiment, the first and second drift section thickness may be between 10 to 100 $\mu$m, exemplarily between 40 $\mu$m to 100 $\mu$m.

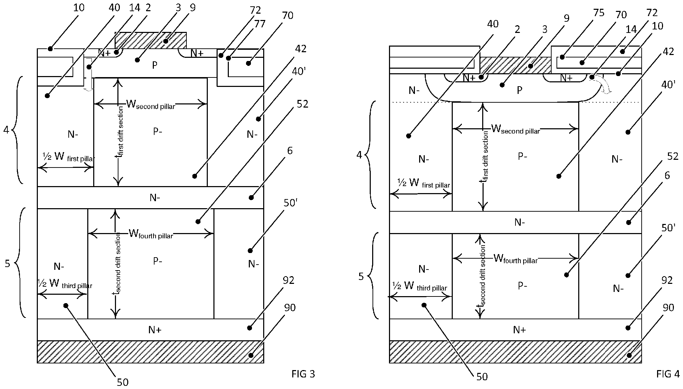

In an exemplary embodiment, the first drift section thickness is the same as the second drift section thickness, whereas in another alternative embodiment, the thicknesses may differ from each other. Such an inventive device is shown in FIG 4. The thickness of the second drift section 5 may be larger or smaller than the thickness of the first drift section 4.

In an exemplary embodiment, a maximum doping concentration in at least one of the first pillar, the second pillar, the third pillar and the fourth pillar is between $1 \times 10^{14}$ to $5 \times 10^{16}$ cm$^{-3}$. The pillars 40, 40', 42, 50, 50', 52 may have a constant doping concentration.

An aspect ratio is a ratio of the thickness of a pillar to a width of said pillar. In another exemplary embodiment, an aspect ratio of at least one of the first pillar, the second pillar, the third pillar and the fourth pillar is between 2 to 50. Exemplarily, the thicknesses of the first pillar and the second pillar are the same and correspond to the thickness of first drift section. The thicknesses of the third pillar and the fourth pillar are the same and correspond to the thickness of second drift section.

The first pillar 40, 40' and the third pillar 50, 50' may be aligned opposite to each other or the pillars may be shifted laterally so that they may partly overlap or be shifted up to the width of the pillars (in which case the first pillar 40, 40' is arranged opposite to the fourth pillar 52).

The separating drift layer 6 may have a drift layer thickness between 2 $\mu$m to 50 $\mu$m, exemplarily between 5 $\mu$m to 20 $\mu$m. Such a thickness ensures that a continuous n doped layer is maintained from the MOS channel 14 to the second main sided layer 96 (i.e. to the drain layer 92 in case of a MOSFET or to a collector layer 94 in the case of an IGBT) even in case of a misalignment of the first pillar 40, 40' and the third pillar 50, 50', i.e. in case in which the first pillar 40, 40' and third pillar 50, 50' are not arranged opposite to each other (in depth direction, i.e. perpendicular to the first main side 10).

The width and / or thickness of the first and third pillars 40, 40', 50, 50' may differ from each other as well as the width and / or thickness of the second and fourth pillar 42, 52, but still fulfilling the formula of the integral of doping concentration and volume.

A maximum doping concentration in the drift layer may be between $1 \times 10^{13}$ to $1 \times 10^{20}$ cm$^{-3}$, exemplarily between $1 \times 10^{14}$ to $1 \times 10^{16}$ cm$^{-3}$. The drift layer 6 may have a constant doping concentration. In another exemplary embodiment, the maximum doping concentration in the drift layer is a factor of 0.1 to 10 different from a maximum doping concentration in the first pillar.

FIG 2 shows an inventive metal-oxide-semiconductor field-effect transistor (MOSFET), which comprises on the second main side 12 an n+ doped drain layer as second main sided layer 96.

FIG 2 concerns an inventive MOSFET having a planar gate electrode 75 as gate electrode 7. The planar gate electrode 75 comprises the gate layer 70 and a first and second insulating layer as insulating layer 72. The first electrically insulating layer is arranged on top of wafer (i.e. on top of the doped layers) on the first main side 10, electrically insulating the gate layer 70 from any n or p doped layer in the wafer (i.e. from the source layer 2, the base layer 3 and the layers in the first drift section 4). The second electrically insulating layer covers the electrically conductive gate layer 70 and, thus, insulates the gate layer 70 from the source electrode 9. Therefore, in between the first and second electrically insulating layers, the electrically conductive gate layer 70 is embedded, exemplarily it is completely embedded. The electrically conductive gate layer 70 is typically made of a heavily doped polysilicon or a metal like aluminum.

Alternatively to an inventive device with a planar gate electrode 75, an inventive device may comprise a gate electrode formed as trench gate electrode 77 as shown in FIG 3. The trench gate electrode 77 comprises an electrically conductive gate layer 70, which is arranged in the same plane as the base layer 3 and adjacent to the source layer 2, separated from each other by a first insulating layer, which also separates and thus insulates the electrically conductive layer 70 from the first drift section 4. A second insulating layer is arranged on top of the electrically conductive layer 70, thus insulating the electrically conductive layer 70 from the first main electrode 9 (FIG 3).

FIG 6 shows another embodiment of an inventive semiconductor device, in which a floating p doped layer 34 is arranged on the fourth pillar 52. The doping concentration of the floating layer is in the range of $1 \times 10^{17}$ cm$^{-3}$ to $1 \times 10^{20}$ cm$^{-3}$ and it has a thickness between 0.2 to 3 $\mu$m. The floating layer 34 does not need to have the same width as the fourth pillar 52, exemplarily it may have a wide width so that it may project the fourth pillar 52. Such a layer improves the electric field characteristics in blocking condition. Electric field peaks may be reduced by the floating layer 34, which may result in improvements in breakdown voltage, safe operating area and cosmic ray induced failure rates.

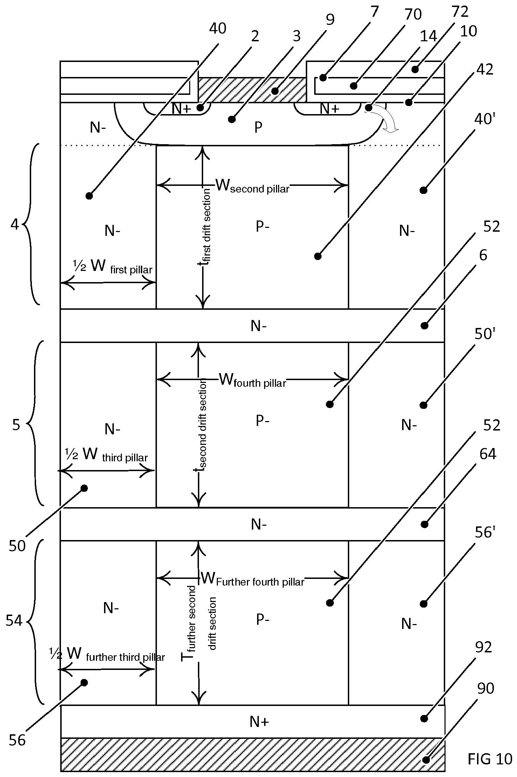

In another exemplary embodiment, between second drift section 5 and the second main side 12 a further second drift section 54 is arranged comprising an n doped further third pillar 56, 56', which is lower doped than the source layer 2, and a p doped further fourth pillar 58, which is arranged alternatingly to the further third pillar 56, 56' (FIG 10). The formula above for the integral of the doping concentration times the volume is fulfilled for pillar A being the further third pillar 56, 56' and pillar B being the further fourth pillar 58.

The second drift section 5 is separated from the further second drift section 54 by a further continuous drift layer 64. With such a further second drift section 54, the thickness of the device may be further enhanced, i.e. higher breakdown voltage may be achieved with such a device. One or more further drift sections 54 and further drift layers 64 may be integrated in an inventive devices.

Between the second drift section 5 or the further second drift section 54 closest to the second main side 12, a further drift layer 64 may be arranged, i.e. which is thus arranged between the second drift section 5 or further second drift section 54 and the second main sided layer 96.

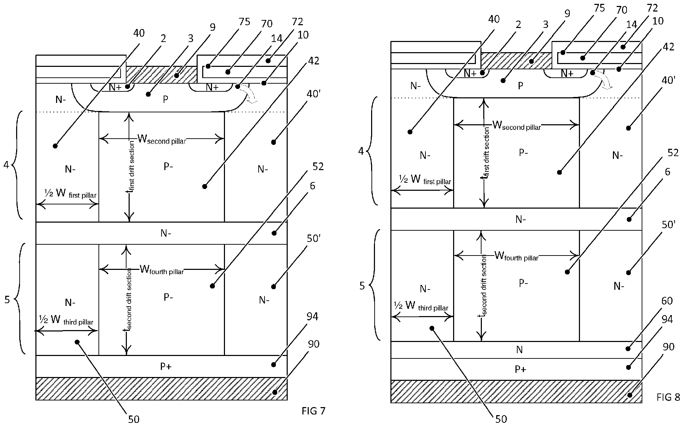

FIG 7 shows an inventive insulated gate bipolar transistor (IGBT) in form of a non punch-through IGBT. As well-known to the experts, such a device having the second drift section 5 arranged directly neighboured to a collector layer 94. Thus, the (n-) doped third pillar 50, 50' is in contact to the collector layer 94 without having a higher doped layer of the first conductivity type (called buffer layer) in between. The electric field in blocking condition for a non-punch-through device is triangular and stops within the third pillar 50, 50'. The space charge region does not reach the collector layer 94.

Alternatively, a buffer layer 60, which has a higher, equal or lower doping concentration than the third pillar 50, 50', may be arranged on the third and fourth pillar 50, 50', 52 towards the second main side 12. A device comprising such a buffer layer 60 (which buffer layer has higher doping concentration than the exemplarily constantly low-doped third pillar 52 or further third pillar 56, i.e. the n doped pillar arranged closest to the second main side 12, either constantly high doped, gradually rising doping concentration or with steadily, continuously increasing IGBT). At higher blocking voltages the electric field at the border between the third pillar 50, 50' and buffer layer 60 will not have reached zero. Along a short distance in the buffer layer 60 it is then steeply decreased to zero due to the high doping concentration.

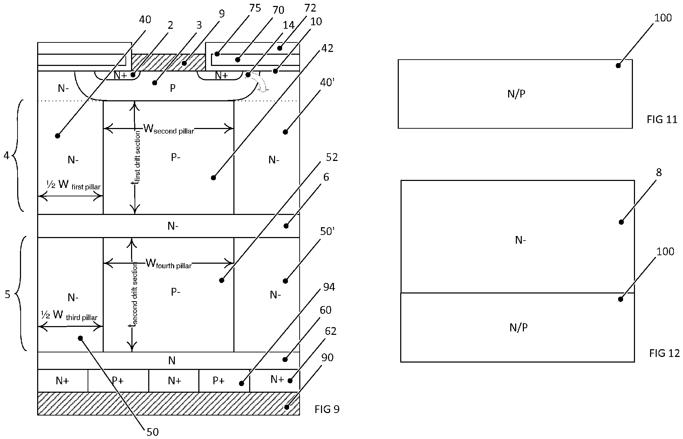

In a further embodiment of the inventive semiconductor IGBT, the p doped collector layer 94 is arranged alternately with an n doped shorts layer 62 in a plane parallel to the second main side 12, thereby forming a reverse conducting IGBT (RC-IGBT) as shown in FIG 9. The buffer layer 60 (if such layer is present in the inventive device) has a higher doping than the first and third pillars 40, 40', 50, 50' and the shorts layer 62 has even a higher doping concentration than the buffer layer 62.

The second main electrode 90 is in direct electrical contact to the shorts layer 62 and the collector layer 94. Both layers may comprise a plurality of p or n doped regions which alternate.

In such a reverse-conducting semiconductor device a freewheeling diode (FWD) is formed between the second main electrode 90, part of which forms a cathode electrode in the diode, the n shorts layer 62, which forms a cathode region in the diode, the first and third pillar 40, 40', 50, 50' together with the drift layer 6 in between, part of which forms the diode base layer, the p base layer 3, part of which forms an anode region in the diode and the first main electrode 9, which forms an anode electrode in the diode.

An insulated gate bipolar transistor (IGBT) is formed between the second main electrode 90, part of which forms the collector electrode in the IGBT, the p type collector layer 94, the drift layer in form of the first and third pillar 40, 40', 50, 50' together with the drift layer 6 in between, part of which forms the IGBT base layer, the p base layer 3, part of which forms a p-base region in the IGBT, the n source layer 2, which forms a n type source region in the IGBT, and the first main electrode 9, which forms an emitter electrode in the IGBT. During on-state of the IGBT a channel is formed between the emitter electrode, the source layer 2 and the p-base layer 3 towards the n-drift layer.

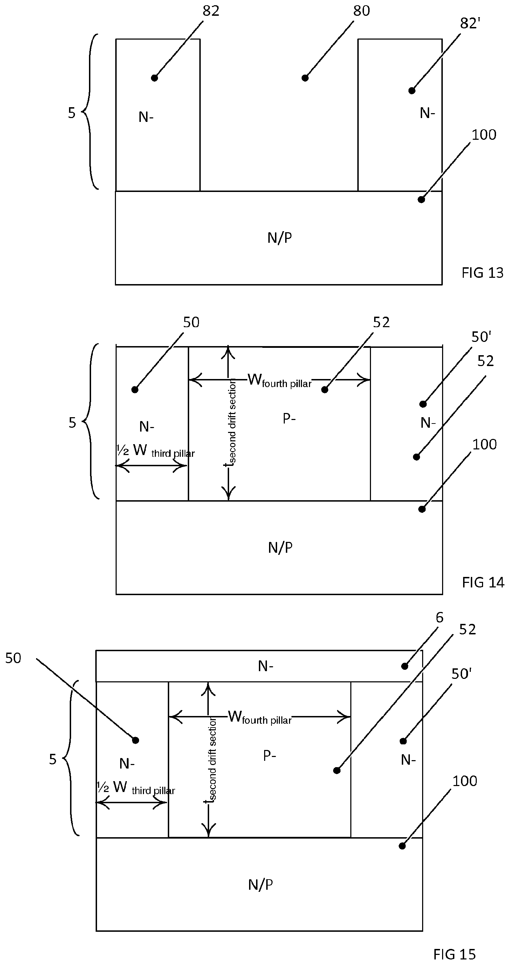

Exemplarily, the RC-IGBT may also be formed as a Bi-mode Insulated Gate Transistor (BIGT) having a large central p doped collector layer 94 surrounded by a mixed area of p doped collector regions and n doped shorts regions. Such a BIGT is disclosed in US 8 212 283 B2 which document is incorporated by reference. For manufacturing an inventive semiconductor device, a semiconductor substrate 100 is provided (FIG 11). Depending on the semiconductor type to be manufactured the substrate 100 may be n doped (for a MOSFET, or a p-channel IGBT) or p doped (for an n-channel IGBT or a p channel MOSFET). Alternatively, any semiconductor substrate may be provided and as described above an epitaxial layer is grown on the substrate. The substrate may be removed in the end, and a second main sided layer 96 (p or n type or first an n buffer layer and then a p collector layer or a p/n alternating layer for a RC-IGBT, depending on the semiconductor type to be created) may be grown on the second main side 12. An epitaxial layer 8 is grown on the substrate 100 (FIG 12). The epitaxial layer may be of n doping type or p doping type, independently of the doping type of the substrate. At least one trench is formed in the epitaxial layer 8, exemplarily by etching (FIG 13). The remaining epitaxial layer forms a pillar 82, 82' or a plurality of pillars 82, 82'. At least one further pillar is formed by filling the at least one trench 80 with a dopant of a different conductivity type than the epitaxial layer 8 (FIG 14). The pillar of the first conductivity type forms the third pillar 50, 50' and the pillar of the second conductivity type forms the fourth pillar 52. The third pillar 50, 50' and the fourth pillar 52 form a second drift section 5. That means that either the epitaxial layer 8 is n type and the trench is filled with a p doped semiconductor material or the epitaxial layer 8 is p type and the trench 80 is filled with an n doped semiconductor material.

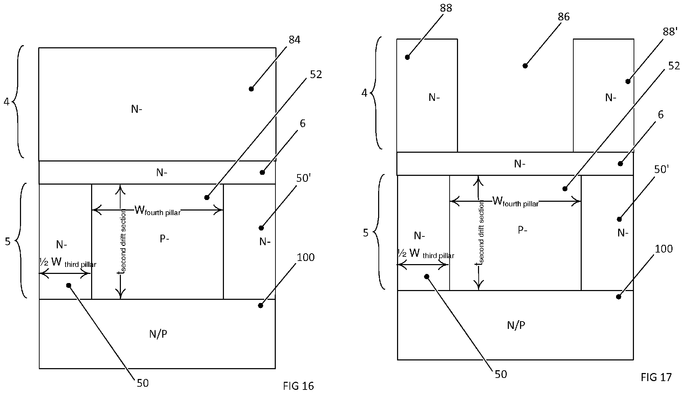

Afterwards, a continuous n- doped drift layer 6 is formed by growing an n- doped epitaxial layer on the first drift section 4 (FIG 15). On the drift layer 6, a further epitaxial layer 84 of the first or second conductivity type is formed (FIG 16). Again, at least one further trench 86 is formed in the further epitaxial layer 84, wherein the remaining further epitaxial layer forms a pillar 88, 88' (FIG 17). The at least one trench is now filled with a dopant of a different conductivity type than the further epitaxial layer 84, wherein the pillar of the first conductivity type forms the first pillar 40, 40' and the pillar of the second conductivity type forms the second pillar 42 (FIG 18). The first pillar 40, 40' and the second pillar 42 form a first drift section 4. That means that either the further epitaxial layer 84 is n type and the further trench 86 is filled with a p dopant or the epitaxial layer 84 is p type and the further trench 86 is filled with an n dopant.

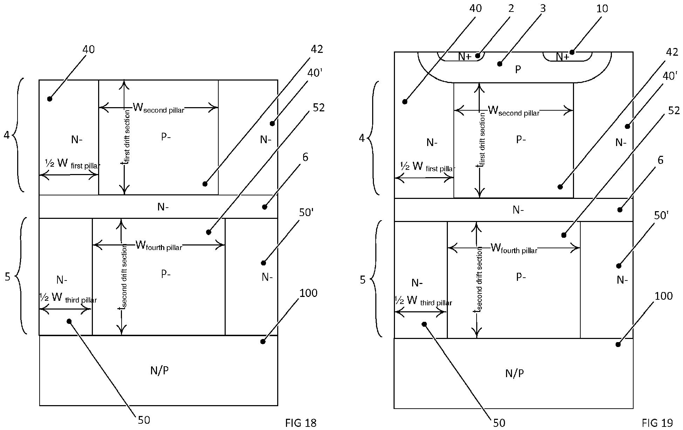

On the first drift section 4, a p doped base layer 3 is formed and then an n doped source layer is formed on the base layer (FIG 19).

A gate electrode 7 is formed on the first main side 10 with an electrically conductive gate layer 70,

which is insulated from any doped layer by an insulating layer 72, wherein a MOS channel 14 is formable from the source layer 2 via the base layer 3 to the first pillar 40, 40'. The gate electrode 7 may be formed as a planar gate electrode 75 or as a trench gate electrode 77.

For the first and second pillar 40, 40', 42 and the third and fourth pillar 50, 50', 52, the following doping concentrations and volume, i.e. thickness, width and length is chosen such that the following relationship applies:

$$\int_0^{V_A} N_A * dV = k * \int_0^{V_B} N_B * dV,$$

wherein

$N_A$ is a local doping concentration in a pillar A,
$V_A$ is a volume of the pillar A,
$N_B$ is a local doping concentration in a pillar B,
$V_B$ is a volume of the pillar B,
k is a factor between 0.8 and 1.2.

The formula is fulfilled for pillar A being the first pillar 40, 40' and pillar B being the second pillar 42, and the formula is fulfilled for pillar A being the third pillar 50, 50' and pillar B being the fourth pillar 52.

Exemplarily, the further epitaxial layer 84 is of n type and of the same doping concentration as the further drift layer 6. This allows to grow the further drift layer 64 and the further epitaxial layer 84 in one manufacturing step.

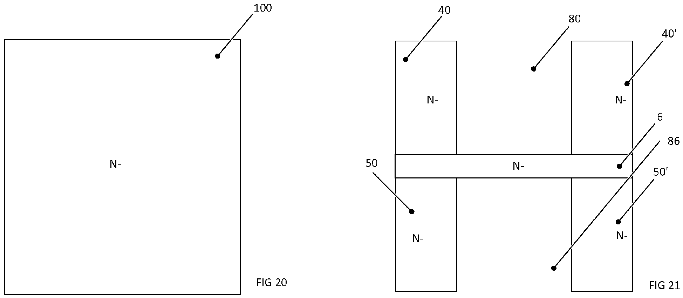

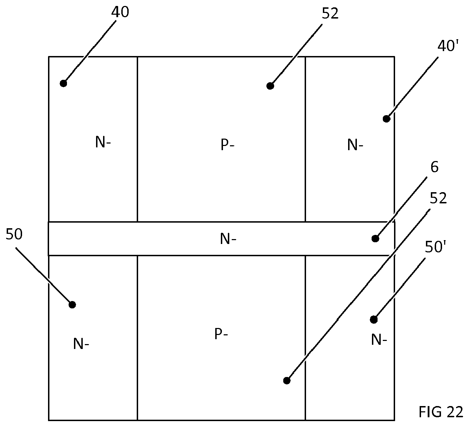

Alternatively, an n- doped substrate 100 may be provided (FIG 20), into which trenches 80 and further trenches 86 are etched on two sides of the substrate opposite to each other (21). The remaining pillars form the first and third pillars 40, 40', 50, 50'. Then the trenches 80, 86 are filled with a p doped semiconductor material, thereby forming the second and fourth pillars 42, 52 (FIG 22). The trenches may also be formed separately on both sides and to fill them in between in order to have a less fragile substrate, i.e. first trenches are formed on one side (either first or second main side 10, 12 and then the trenches are filled with a dopant of aa different conductivity type. Afterwards, trenches are formed on the other main side 12, 10 and then filled with a dopant of the same conductivity type as the one, with which the trenches on the other side have been filled with. Afterwards, the second main sided layer 96 and the first main sided layers, i.e. the base layer 3 and the source layer 2 are formed. On the first main side 10, then a gate electrode 7 is formed and the first main electrode 9 is formed. On the second main side 12, the second main electrode is formed 90.

In a further alternative manufacturing method, first drift section 4 and second drift section 5 can be manufactured separately (each providing a substrate, forming an epitaxial layer on it, etching trenches and filling the trenches with a dopant of a different conductivity type than the dopant of the epitaxial layer) and using a joining technology (for example wafer bonding) to connect the two separate superjunction structures.

In an exemplary embodiment, the conductivity types of the layers are switched, i.e. all layers of the first conductivity type are p type (e.g. the first pillar 50, 50', third pillar 50, 50', drift layer 6) and all layers of the second conductivity type are n type (e.g. the second pillar 42, fourth third pillar 52, base layer 3).

*Reference List*

| | |
|---|---|
| 1 | MOS cell |
| 10 | first main side |
| 12 | second main side |
| 2 | source layer |
| 3 | base layer |
| 30 | contact base layer |
| 32 | base region |
| 34 | floating layer |
| 4 | first drift section |
| 40 | first pillar |
| 42 | second pillar |
| 44 | pillar width |
| 5 | second drift section |
| 50 | third pillar |
| 52 | fourth pillar |
| 54 | further second drift section |
| 56 | further third pillar |
| 58 | further fourth pillar |
| 6 | drift layer |
| 60 | buffer layer |
| 62 | shorts layer |
| 64 | further drift layer |
| 7 | gate electrode |
| 70 | electrically conductive layer |
| 72 | insulating layer |
| 75 | planar gate electrode |
| 77 | trench gate electrode |
| 100 | semiconductor substrate |
| 8 | epitaxial layer |
| 80 | trench |
| 82 | pillar |
| 84 | further epitaxial layer |
| 84 | trench |
| 9 | first main electrode |
| 90 | second main electrode |
| 92 | drain layer |
| 94 | collector layer |
| 96 | second main sided layer |

**Claims**

**1.** A semiconductor device comprising a MOS cell (1) having from a first main side (10) to a second main side (12) opposite to the first main side (10) following layers:

- a source layer (2) of a first conductivity type,
- a base layer (3) of a second conductivity type different from the first conductivity type,
- a first drift section (4) comprising a first pillar (40, 40') of the first conductivity type, which is lower doped than the source layer (2), and a second pillar (42) of the second conductivity type, which is arranged alternatingly to the first pillar (40, 40'),

wherein a gate electrode (7) is arranged on the first main side (10), which gate electrode (7) comprises an electrically conductive gate layer (70), which is insulated from any doped layer by an insulating layer (72), and wherein a MOS channel (14) is formable from the source layer (2) via the base layer (3) to the first pillar (40, 40'), **characterized in, that** between the first drift section (4) and the second main side (12) a second drift section (5) is arranged comprising a third pillar (50, 50') of the first conductivity type, which is lower doped than the source layer (2), and a fourth pillar (52) of the second conductivity type, which is arranged alternatingly to the third pillar (50, 50'), **in that** the first drift section (4) is separated from the second drift section (5) by a continuous drift layer (6) of the first conductivity type, **in that** a formula is fulfilled:

$$\int_0^{V_A} N_A * dV = k * \int_0^{V_B} N_B * dV,$$

wherein

$N_A$ is a local doping concentration in a pillar A,
$V_A$ is a volume of the pillar A,
$N_B$ is a local doping concentration in a pillar B,
$V_B$ is a volume of the pillar B,
k is a factor between 0.8 and 1.2, and **in that**

the formula is fulfilled for pillar A being the first pillar (40, 40') and pillar B being the second pillar (42), and **in that** the formula is fulfilled for pillar A being the third pillar (50, 50') and pillar B being the fourth pillar (52).

**2.** The semiconductor device according to claim 1, **characterized in, that** a drift layer thickness is between 2 $\mu$m to 50 $\mu$m or between 5 $\mu$m to 20 $\mu$m.

**3.** The semiconductor device according to anyone of the claims 1 and 2, **characterized in, that** a maximum doping concentration in the drift layer (6) is between 1 x $10^{13}$ to 1 x $10^{20}$ cm$^{-3}$ or between 1 x $10^{14}$ to 1 x $10^{16}$ cm$^{-3}$.

4. The semiconductor device according to anyone of the claims 1 to 3, **characterized in, that** a maximum doping concentration in the drift layer (6) is a factor of 0.1 to 10 different from a maximum doping concentration in the first pillar (40, 40').

5. The semiconductor device according to anyone of the claims 1 to 4, **characterized in, that** a thickness of at least one of the first drift section (4) and the second drift section (5) is between 10 $\mu$m to 100 $\mu$m or between 40 $\mu$m to 100 $\mu$m.

6. The semiconductor device according to anyone of the claims 1 to 5, **characterized in, that** the thickness of the first drift section (4) is the same as the thickness of the second drift section (5).

7. The semiconductor device according to anyone of the claims 1 to 5, **characterized in, that** the thickness of the first drift section (4) differs from the thickness of the second drift section (5).

8. The semiconductor device according to anyone of the claims 1 to 7, **characterized in, that** a maximum doping concentration in at least one of the first pillar (40, 40'), the second pillar (42), the third pillar (50, 50') and the fourth pillar (52) is between $1 \times 10^{14}$ to $5 \times 10^{16}$ cm$^{-3}$.

9. The semiconductor device according to anyone of the claims 1 to 8, **characterized in, that** an aspect ratio, which is a ratio of a thickness of a pillar to a width of said pillar, of at least one of the first pillar, the second pillar, the third pillar and the fourth pillar is between 2 to 50.

10. The semiconductor device according to anyone of the claims 1 to 9, **characterized in, that** between second drift section (5) and the second main side (12) a further second drift section (54) is arranged comprising a further third pillar (56, 56') of the first conductivity type, which is lower doped than the source layer (2), and a further fourth pillar (58) of the second conductivity type, which is arranged alternatingly to the further third pillar (56, 56'), **in that** the second drift section (5) is separated from the further second drift section (54) by a further continuous drift layer (64) of the first conductivity type, and **in that** the formula is fulfilled for pillar A being the further third pillar (56, 56') and pillar B being the further fourth pillar (58).

11. The semiconductor device according to anyone of the claims 1 to 10, **characterized in, that** the doped layers are made of a wide bandgap material or of silicon carbide.

12. The semiconductor device according to anyone of the claims 1 to 11, **characterized in, that** the first pillar (40, 40') and the third pillar (50, 50') are aligned opposite to each other.

13. The semiconductor device according to anyone of the claims 1 to 12, **characterized in, that** the factor k is between 0.9 and 1.1 or between 0.95 and 1.05.

14. A method for manufacturing a semiconductor device according to anyone of the claims 1 to 13, **characterized in, that**

   - providing a semiconductor substrate (100) of a first or second conductivity type,
   - growing an epitaxial layer (8) of the first or second conductivity type on the substrate (100),
   - forming at least one trench (80) in the epitaxial layer (8), wherein the remaining epitaxial layer forms a pillar,
   - forming a further pillar by filling the at least one trench (80) with a dopant of a different conductivity type than the epitaxial layer (8), wherein the pillar of the first conductivity type forms the first pillar (40, 40') and the pillar of the second conductivity type forms the second pillar (42) and the first pillar (40, 40') and the second pillar (42) form a first drift section (4),
   - forming a continuous drift layer (6) of the first conductivity type by growing an epitaxial layer of the first conductivity type on the first drift section (4),
   - growing a further epitaxial layer (84) of the first or second conductivity type on the drift layer (6),
   - forming at least one further trench (86) in the further epitaxial layer (84), wherein the remaining further epitaxial layer forms a pillar,
   - forming a pillar by filling the at least one trench with a dopant of a different conductivity type than the further epitaxial layer (84), wherein the pillar of the first conductivity type forms the third pillar (50, 50') and the pillar of the second conductivity type forms the fourth pillar (52) and the third pillar (50, 50') and the fourth pillar (52) form a second drift section (5),
   - forming a base layer (3) of the second conductivity type on the second drift section (5), and
   - forming a source layer (2) of the second conductivity type on the base layer (3),
   - forming a gate electrode (7) on the first main side (10) with an electrically conductive gate layer (70), which is insulated from any doped layer by an insulating layer (72), wherein a MOS channel (14) is formable from the source layer (2) via the base layer (3) to the first pillar (40, 40'),
   - wherein a formula is fulfilled:

$$\int_0^{V_A} N_A * dV = k * \int_0^{V_B} N_B * dV,$$

wherein

$N_A$ is a local doping concentration in a pillar A,
$V_A$ is a volume of the pillar A,
$N_B$ is a local doping concentration in a pillar B,
$V_B$ is a volume of the pillar B,
k is a factor between 0.8 and 1.2, and **in that**

the formula is fulfilled for pillar A being the first pillar (40, 40') and pillar B being the second pillar (42), and the formula is fulfilled for pillar A being the third pillar (50, 50') and pillar B being the fourth pillar (52).

15. A method for manufacturing a semiconductor device according to claim 14, **characterized in, that** forming the further epitaxial layer (84) is of the first conductivity type and of the same doping concentration as the drift layer (6).

$$\int_0^{V_A} N_A * dV = k * \int_0^{V_B} N_B * dV,$$

FIG 1

FIG 2

FIG 3

FIG 4

FIG 5

FIG 6

FIG 7

FIG 8

FIG 9

FIG 11

FIG 12

FIG 10

FIG 13

FIG 14

FIG 15

FIG 16

FIG 17

FIG 18

FIG 19

100

N-

FIG 20

40

80

40'

N-

N-

50

6

86

N-

50'

N-

N-

FIG 21

FIG 22

FIG 23

Europäisches
Patentamt

European
Patent Office

Office européen
des brevets

# EUROPEAN SEARCH REPORT

Application Number

EP 16 19 2747

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 093 522 B1 (ZENG JUN [US] ET AL) 28 July 2015 (2015-07-28) * column 6, line 11 - column 8, line 67; figures 2P, 8B * | 1-15 | INV. H01L29/78 H01L29/06 H01L29/08 H01L21/336 H01L29/739 H01L21/331 |
| A | JP 2007 036213 A (TOSHIBA CORP) 8 February 2007 (2007-02-08) * paragraph [0039] * | 9,11 | |
| A | US 2008/272429 A1 (ISHIGURO TAKESHI [JP]) 6 November 2008 (2008-11-06) * paragraphs [0066], [0067] * | 14 | |
| A,D | US 6 693 323 B2 (SATO TAKAHIRO [JP] ET AL) 17 February 2004 (2004-02-17) * figures 27-30,34-36 * | 14 | |

TECHNICAL FIELDS
SEARCHED (IPC)

H01L

The present search report has been drawn up for all claims

| Place of search | Date of completion of the search | Examiner |
|---|---|---|
| Munich | 28 February 2017 | Diaz Alvarez, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 19 2747

This annex lists the patent family members relating to the patent documents cited in the above-mentioned European search report.
The members are as contained in the European Patent Office EDP file on
The European Patent Office is in no way liable for these particulars which are merely given for the purpose of information.

28-02-2017

| Patent document cited in search report | | | Publication date | Patent family member(s) | | | Publication date |
|---|---|---|---|---|---|---|---|
| US 9093522 | | B1 | 28-07-2015 | CN | 105431946 | A | 23-03-2016 |
| | | | | TW | M516231 | U | 21-01-2016 |
| | | | | TW | 201535712 | A | 16-09-2015 |
| | | | | US | 9093522 | B1 | 28-07-2015 |
| | | | | WO | 2015119709 | A1 | 13-08-2015 |
| JP 2007036213 | | A | 08-02-2007 | NONE | | | |
| US 2008272429 | | A1 | 06-11-2008 | TW | 200845381 | A | 16-11-2008 |
| | | | | US | 2008272429 | A1 | 06-11-2008 |
| | | | | WO | 2008136874 | A1 | 13-11-2008 |
| US 6693323 | | B2 | 17-02-2004 | US | 6475864 | B1 | 05-11-2002 |
| | | | | US | 2003008483 | A1 | 09-01-2003 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6693323 B2

- US 8212283 B2